# EUROPEAN PATENT APPLICATION

(11) **EP 4 830 912 A1**
(43) Date of publication of application: **28.10.2026**
(21) Application number: 24907311.5
(22) Date of filing: 12.12.2024
(51) Int. Cl.: B32B 9/00, B32B 27/32, B65D 65/40

(54) **METHOD FOR PRODUCING GAS BARRIER FILM, GAS BARRIER FILM, PACKAGING MATERIAL FILM, AND PACKAGING MATERIAL**

(30) Priority: 21.12.2023 JP 2023216068
(71) Applicant: Toppan Holdings Inc., Tokyo 110-0016 (JP)
(72) Inventor: NISHIKAWA, Yohei, Tokyo 110-0016 (JP); KISHIZAWA, Shuhei, Tokyo 110-0016 (JP); WATANABE, Tempei, Tokyo 110-0016 (JP); FURUTA, Tatsuro, Tokyo 110-0016 (JP); USUKI, Junji, Tokyo 110-0016 (JP)
(74) Representative: Hoffmann Eitle
(86) International application number: PCT/JP2024/044078
(87) International publication number: WO 2025/134926

(57) **Abstract**

The disclosure provides a method of producing a gas barrier film, including steps of forming an inorganic oxide layer on a substrate layer; applying an active energy beam-curable resin composition onto the inorganic oxide layer to form a coating film; and forming an overcoat layer by irradiating the coating film with active energy beams and curing the coating film, wherein the active energy beam-curable resin composition contains an acrylic compound with a molecular weight of 300 or more.

## Description

### [Technical Field]

The present disclosure relates to methods of producing a gas barrier film, gas barrier films produced using the production methods, packaging films including the gas barrier films, and packaging materials formed into a bag shape from the packaging films.

### [Background Art]

Packaging materials used for packaging food products, pharmaceutical products, electronic parts, mechanical parts, etc. are required to have properties preventing entry of gases (water vapor, oxygen, etc.) that deteriorate the contents, i.e., are required to have gas barrier properties, to protect the contents from deterioration, decay, and the like, and retain the functions and nature of the contents. Therefore, these packaging materials use films having gas barrier properties (gas barrier films).

As a packaging film including a gas barrier film, PTL 1, for example, proposes a laminated material produced by: preparing a polyurethane-based resin composition by mixing a polyurethane-based resin, nitrocellulose, silane coupling agent, and filler with a solvent/diluent; providing an inorganic oxide thin film, which is mainly formed of a silicon oxide film deposited by plasma-enhanced chemical vapor deposition, to one surface of a flexible plastic substrate; applying the polyurethane-based resin composition to a surface of the inorganic oxide thin film provided to one surface of the flexible plastic substrate to form a thin coating film made of the polyurethane-based resin composition; applying an adhesive made of a two-part curing type polyurethane-based resin, which forms a coating film by curing reaction of a polyester polyol or polyether polyol with an isocyanate, to the surface of the thin coating film of the polyurethane-based resin composition; and then laminating at least a heat-sealing resin layer via the adhesive layer.

### [Citation List]

### [Patent Literature]

PTL 1: JP2000167973A

### [Summary of the Invention]

### [Technical Problem]

In general, gas barrier films are produced by providing a gas barrier layer made of a material having gas barrier properties on the surface of a resin substrate. For example, in the case of the above PTL 1, the thin coating film of the polyurethane-based resin composition corresponds to the gas barrier layer. The thin coating film is formed by applying the polyurethane-based resin composition to an object using wet coating such as roll coating, followed by hot air drying to remove the solvent.

However, the substrate film may be deformed by heat during the hot air drying, causing cracking in the gas barrier layer, thereby deteriorating the gas barrier properties (oxygen barrier properties in particular). From the perspective of improving recyclability in recent years, there is a trend of using polyolefin-based resin films such as of oriented polypropylene (OPP) and polyethylene (PE) as substrate films in order to design packaging materials using a single polyolefin-based material; however, such films are easily affected by the above heat and raises a greater concern for deterioration of gas barrier properties.

The present disclosure has been provided in light of the above circumstances and aims to provide a method of producing a gas barrier film which is able to exhibit excellent gas barrier properties regardless of the heat resistance of the substrate film.

The present disclosure also aims to provide a gas barrier film produced using the production method, a packaging film including the gas barrier film, and a packaging material formed into a bag shape from the packaging film.

### [Solution to Problems]

In order to achieve the above issues, the present inventors have found that it is important to form a gas barrier layer by curing a resin composition containing a specific acrylic compound using active energy beams, and completed the production method of the present disclosure. Specifically, the present disclosure has aspects of providing the following invention.
[1] A method of producing a gas barrier film, including steps of
   forming an inorganic oxide layer on a substrate layer;
   applying an active energy beam-curable resin composition onto the inorganic oxide layer to form a coating film; and
   forming an overcoat layer by irradiating the coating film with active energy beams and curing the coating film, wherein
   the active energy beam-curable resin composition contains an acrylic compound with a molecular weight of 300 or more.
[2] A gas barrier film, including
   a substrate layer, an inorganic oxide layer, and an overcoat layer in this order, wherein
   the overcoat layer is a cured product of an active energy beam-curable resin composition having a crosslinked structure; and
   the active energy beam-curable resin composition contains an acrylic compound with a molecular weight of 300 or more.
[3] The gas barrier film according to [2], wherein the active energy beam-curable resin composition contains the acrylic compound having an isocyanurate skeleton.
[4] The gas barrier film according to [3], wherein the active energy beam-curable resin composition contains two or more types of the acrylic compound having an isocyanurate skeleton.
[5] The gas barrier film according to [3] or [4], wherein a content of a hydroxyl group-containing acrylic compound having an isocyanurate skeleton is 30 mass% or more relative to a total mass of the acrylic compound having an isocyanurate skeleton.
[6] The gas barrier film according to [2] to [5], wherein the active energy beam-curable resin composition further contains an acrylic compound with a molecular weight of less than 300.
[7] The gas barrier film according to any one of [2] to [6], wherein the active energy beam-curable resin composition further contains a carboxyl group-containing acrylic compound with a molecular weight of less than 300.
[8] The gas barrier film according to [6], wherein a content of the acrylic compound with a molecular weight of less than 300 is 10 to 2,000 parts by mass relative to 100 parts by mass of the acrylic compound with a molecular weight of 300 or more.
[9] The gas barrier film according to [7], wherein the carboxyl group-containing acrylic compound has a molecular weight of 100 or more and less than 300.
[10] The gas barrier film according to [7] or [9], wherein a content of the carboxyl group-containing acrylic compound is 10 to 600 parts by mass relative to 100 parts by mass of the acrylic compound with a molecular weight of 300 or more.
[11] The gas barrier film according to any one of [2] to [10], wherein the substrate layer contains a polyolefin-based resin.
[12] The gas barrier film according to any one of [2] to [11], wherein the overcoat layer has a thickness of 0.15 µm to 2 µm.
[13] A packaging film including the gas barrier film according to any one of [2] to [12], and a heat-sealing layer provided on the overcoat layer of the gas barrier film.
[14] A packaging material formed into a bag shape from the packaging film according to [13].

### [Advantageous Effects of the Invention]

According to the present disclosure, there is provided a method of producing a gas barrier film which is able to exhibit excellent gas barrier properties regardless of the heat resistance of the substrate film.

Furthermore, according to the present disclosure, there are provided a gas barrier film produced using the production method, a packaging film including the gas barrier film, and a packaging material formed into a bag shape from the packaging film.

### [Brief Description of the Drawings]

FIG. 1 is a schematic cross-sectional view illustrating a gas barrier film according to a first embodiment of the present disclosure.
FIG. 2 is a schematic cross-sectional view illustrating a gas barrier film according to a second embodiment of the present disclosure.

### [Description of the Embodiments]

Referring to the drawings, some embodiments of the present disclosure will be described. The embodiments described below are more specific implementations of any of the aspects set forth above. The matters described below can be incorporated into the aspects set forth above, either alone or in combination.

The embodiments described below are merely example configurations for embodying the technical idea of the present disclosure, and the technical idea of the present disclosure should not be limited by the materials, shapes, structures, and the like of the components described below. Various modifications can be added to the technical idea of the present disclosure within the technical scope recited in the claims.

In the drawings, components identical with each other are denoted by the same reference signs. The drawings are only schematic, and the relationships between dimensions in one direction and another direction, dimensions of a component and another component, and the like may be different from actual relationships.

In the present disclosure, the oxygen barrier properties, which are an aspect of gas barrier properties, are evaluated based on oxygen transmission rate (OTR), and the smaller the value, the better the oxygen barrier properties.

### <Gas barrier film>

A gas barrier film includes a substrate layer, an inorganic oxide layer, and an overcoat layer in this order.

The overcoat layer is a cured product of an active energy beam-curable resin composition having a crosslinked structure, and the active energy beam-curable resin composition contains an acrylic compound with a molecular weight of 300 or more.

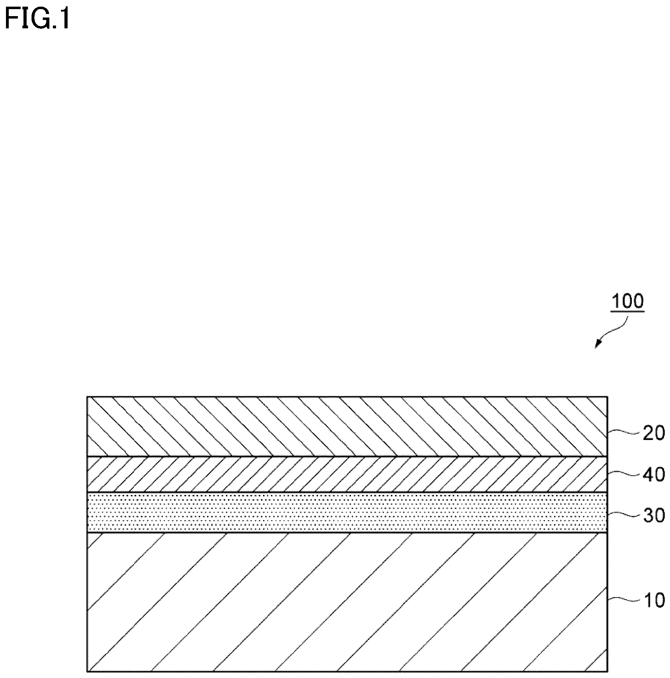

First, referring to FIG. 1, a first embodiment will be described.

FIG. 1 is a schematic cross-sectional view illustrating a gas barrier film according to a first embodiment of the present disclosure. A gas barrier film 100 includes a substrate layer 10, a primer layer 30, an inorganic oxide layer 40, and an overcoat layer 20 in this order.

The primer layer 30 is formed on the substrate layer 10. The inorganic oxide layer 40 is formed on the primer layer 30. The overcoat layer 20 is formed on the inorganic oxide layer 40.

As will be described in the second embodiment, a gas barrier film does not have to include the primer layer 30.

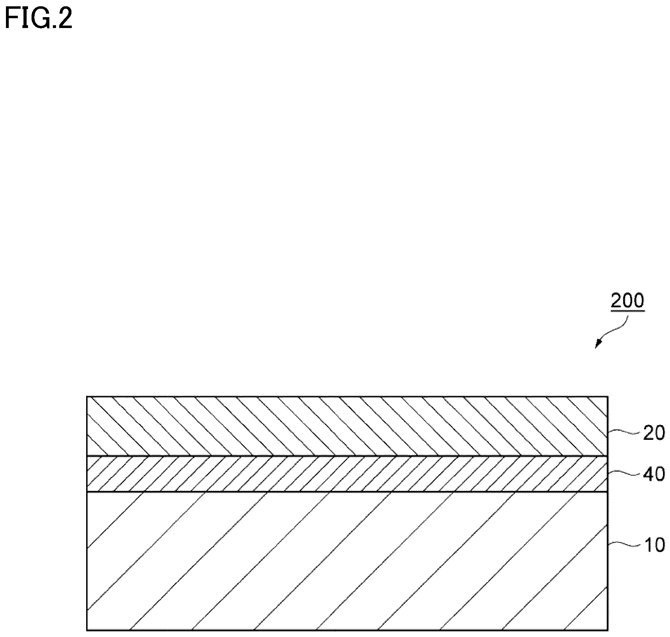

Next, referring to FIG. 2, a second embodiment will be described.

FIG. 2 is a schematic cross-sectional view illustrating a gas barrier film according to a second embodiment of the present disclosure. A gas barrier film 200 has a structure in which the primer layer 30 is omitted from the gas barrier film 100, and includes a substrate layer 10, an inorganic oxide layer 40, and an overcoat layer 20 in this order.

In the following, the gas barrier layers according to the first and second embodiments will be described.

### [Substrate Layer]

Examples of the resin for forming the substrate layer 10 include olefin-based resins such as polyethylene, polypropylene, olefin polymers having 2 to 10 carbon atoms, and propyleneethylene copolymers; polyester-based resins such as polyethylene terephthalate and polybutylene terephthalate; polyamide-based resins such as aliphatic polyamides such as nylon 6 and nylon 66, and aromatic polyamides such as polymetaxylylene adipamide; vinyl-based resins such as polystyrene, polyvinyl acetate, ethylene-vinyl acetate copolymers, polyvinyl alcohol, and ethylene-vinyl alcohol copolymers; acrylic resins such as homopolymers and copolymers of acrylic monomers such as polymethylmethacrylate and polyacrylonitrile; cellophane; and engineering plastics such as polycarbonate and polyimide. These resins may be used singly or in combination of two or more.

Of these resins, use of a polyolefin-based resin film (polypropylene film in particular) can achieve a monomaterial packaging material having excellent recyclability.

The substrate layer 10 may be either a single layer film made of a single resin, or a single-layer or laminated film made of multiple resins. In the substrate layer 10, any of the various resins mentioned above may be laminated on other substrates (metal, wood, paper, ceramics, etc.)

The film constituting the substrate layer 10 may be an unstretched film or may be a stretched film such as a uniaxially or biaxially stretched film. An oriented polypropylene (OPP) film is particularly preferable as the substrate layer 10 from the perspective of having excellent water vapor barrier properties. If the substrate layer 10 includes an OPP film, the OPP film may have a single-layer structure or two or more-layer structure.

The OPP film may be a film obtained by processing at least one polymer selected from homopolymers, random copolymers, and block copolymers into a film shape. Homopolymers are polypropylenes composed of only propylene monomers. Random copolymers are polypropylenes having a main propylene monomer randomly copolymerized with a small amount of comonomer different from the propylene to form a homogeneous phase. Block copolymers are polypropylenes composed of a main propylene monomer copolymerized with the above comonomer in blocks or polymerized in a rubber-like manner to form a heterogeneous phase.

The surface of the substrate layer 10 on which the primer layer 30 or the inorganic oxide layer 40 is formed may undergo surface treatment such as chemical treatment, solvent treatment, corona treatment, low-temperature plasma treatment, or ozone treatment. This may improve adhesion between the substrate layer and the primer layer or the inorganic oxide layer.

The film constituting the substrate layer 10 may contain additives such as fillers, antiblocking agents, antistatic agents, plasticizers, lubricants, and antioxidants. These additives may be used singly or in combination of two or more.

The thickness of the substrate layer 10 is not particularly limited, but can be appropriately determined depending on the cost and application, while considering suitability as a packaging material and suitability for lamination with other coating films. In practical use, it is preferable that the thickness of the substrate layer 10 is 3 µm to 200 µm, more preferably 5 µm to 120 µm, even more preferably 6 µm to 100 µm, and particularly preferably 10 µm 30 µm.

### [Primer layer]

The primer layer 30 contains an organic polymer. The content of the organic polymer in the primer layer 30 may be, for example, 70 mass% or more or may be preferably 80 mass% or more. Examples of the organic polymer include polyacrylic resins, polyester resins, polycarbonate resins, polyol resins, polyurethane resins, polyamide resins, polyolefin resins, polyimide resins, melamine resins, and phenolic resins. Considering hot water resistance for adhesion strength between the substrate layer 10 and the inorganic oxide layer 40 or the overcoat layer 20, the primer layer 30 preferably contains at least one of polyacrylic resins, polyol-based resins, polyurethane-based resins, polyamide-based resins, and reaction products of these organic polymers.

The primer layer 30 may contain a silane coupling agent, organic titanate, modified silicone oil, or the like.

The organic polymer used for the primer layer 30 is more preferably an organic polymer having a urethane bond which is produced by reaction of a polyol having two or more hydroxyl groups at a molecular end or in a molecular chain with an isocyanate compound, or an organic polymer containing a reaction product of a polyol having two or more hydroxyl groups at a molecular end or in a molecular chain with an organosilane compound such as a silane coupling agent or a hydrolysate thereof. Either one of or both of these may be used.

The polyol may be, for example, at least one selected from an acrylic polyol, polyvinyl acetal, polystyrene polyol, polyurethane polyol, and the like. The acrylic polyol may be obtained by polymerizing an acrylic acid derivative monomer, or may be obtained by copolymerizing an acrylic acid derivative monomer with other monomers. The acrylic acid derivative monomer may be ethyl methacrylate, hydroxyethyl methacrylate, hydroxypropyl methacrylate, hydroxybutyl methacrylate, or the like. Monomers copolymerized with the acrylic acid derivative monomer may be styrene, or the like.

The isocyanate compound has a function of enhancing adhesion between the substrate layer 10 and the inorganic oxide layer 40 or the overcoat layer 20 due to the urethane bond produced by reaction with a polyol. In other words, the isocyanate compound serves as a crosslinking agent or curing agent. Examples of the isocyanate compound include monomers such as aromatic tolylene diisocyanate (TDI), diphenylmethane diisocyanate (MDI), aromatic aliphatic xylene diisocyanate (XDI), aliphatic hexamethylene diisocyanate (HMDI), isophorone diisocyanate (IPDI), a mixture of 1-methylcyclohexane-2,4-diisocyanate and 1-methylcyclohexane-2,6-diisocyanate (HTDI, hydrogenated TDI), cyclohexylmethane diisocyanate (HMDI, hydrogenated MDI), and polymers and derivatives of these. These isocyanate compounds may be used singly or in combination of two or more.

Examples of the silane coupling agent include vinyltrimethoxysilane, vinyltriethoxysilane, 3-chloropropylmethyldimethoxysilane, 3-chloropropyltrimethoxysilane, 3-glycidyloxypropylmethyldimethoxysilane, 3-glycidyloxypropyltrimethoxysilane, 3-glycidyloxypropylmethyldiethoxysilane, 3-glycidyloxypropyltriethoxysilane, 3-methacryloyloxypropyltrimethoxysilane, and 3-methacryloyloxypropylmethyldimethoxysilane. The organosilane compound may be a hydrolysate of these silane coupling agents. The organosilane compound may contain one, or two or more in combination, of the above silane coupling agents and hydrolysates thereof.

The primer layer 30 can be formed using a mixed liquid obtained by mixing the above components in an organic solvent at any ratio. The mixed liquid may contain, for example, curing accelerators such as tertiary amines, imidazole derivatives, metal salt compounds of carboxylic acid, quaternary ammonium salts, and quaternary phosphonium salts; antioxidants such as phenols, sulfurs, and phosphites; leveling agents; flow modifiers; catalysts; crosslinking reaction accelerators; and fillers.

The thickness of the primer layer 30 is not particularly limited but may be, for example, 0.005 µm to 5 µm. The thickness can be appropriately determined depending on the application or required properties. The thickness of the primer layer 30 is preferably 0.01 µm to 1 µm, and more preferably 0.01 µm to 0.5 µm. If the thickness of the primer layer 30 is 0.01 µm or more, sufficient adhesion strength can be achieved between the substrate layer 10 and the inorganic oxide layer 40 or the overcoat layer 20, and gas barrier properties can also be enhanced. If the thickness of the primer layer 30 is 1 µm or less, a uniform coating surface can be easily formed, and drying load or production cost can be reduced.

As shown in FIG. 2, if no primer layer is provided, heating processes involving the substrate layer can be reduced. However, provision of a primer layer can easily improve smoothness of the substrate layer surface, and therefore deterioration of gas barrier properties can be suppressed which is due to deterioration of the inorganic oxide layer.

### [Inorganic oxide layer]

Examples of the inorganic oxide constituting the inorganic oxide layer 40 include aluminum oxide, silicon oxide, magnesium oxide, titanium oxide, tin oxide, zinc oxide, and indium oxide. In particular, aluminum oxide or silicon oxide is preferable due to having good productivity, and having good oxygen barrier properties and water vapor barrier properties under high temperature and high humidity conditions. The inorganic oxide layer 40 may be formed of one inorganic oxide or may be formed of two or more appropriately selected inorganic oxides.

The inorganic oxide layer 40 preferably has a thickness of 1 nm to 200 nm. If the thickness is 1 nm or more, excellent oxygen barrier properties and water vapor barrier properties can be easily achieved. If the thickness is 200 nm or less, production cost can be minimized, cracking is less likely to occur due to external forces such as bending and pulling, and deterioration of gas barrier properties can be easily suppressed.

The inorganic oxide layer 40 can be formed using a known film-forming method, examples of which include vacuum vapor deposition, sputtering, ion plating, and plasma-enhanced chemical vapor deposition (CVD).

### [Overcoat layer (gas barrier coating film / oxygen barrier coating film)]

The overcoat layer 20 is obtained by curing a coating film containing an acrylic compound (compound having acryloyl groups), an example of which may be an organic polymer film obtained by applying a solvent-free coating liquid containing a monomer or oligomer of an acrylic compound, i.e., an active energy-beam curable resin composition, and curing the coating film by irradiation of active energy beams such as electron beams (EB) or ultraviolet light (UV). As can be understood from the production method, the overcoat layer is a cured product of an active energy beam-curable resin composition having a crosslinked structure.

The active energy beam-curable resin composition contains at least a monomer (or oligomer) of an acrylic compound, and may further contain a methacrylic compound (compound having methacryloyl groups), photoradical generator, silane coupling agent, etc. as additives. Use of EB can cure the above composition even if it does not contain a photoradical generator. From a hygiene perspective, the above composition does not necessarily have to contain a photoradical generator.

Acrylic compounds, which can be obtained at low cost in general, are active energy beam-curable compounds with superior EB or UV curing speeds compared to methacrylic compounds. The active energy beam-curable resin composition may contain one or two or more acrylic compounds.

Active energy beam-curable resin compositions contain an acrylic compound with a molecular weight of 300 or more. In general, a coating film made of an acrylic compound tends to have poor gas barrier properties, or poor oxygen barrier properties in particular; however, use of an acrylic compound with a molecular weight of 300 or more allows the coating film to exhibit better gas barrier properties compared to the case of using an acrylic compound with a molecular weight of less than 300. From this perspective, the molecular weight is preferably 350 or more. From the perspective of coatability as a resin composition, the upper limit of the molecular weight can be 1,900 or less; however, from the perspective of achieving even better coatability, the molecular weight may be preferably 1,000 or less, more preferably 700 or less, and even more preferably 500 or less.

From the perspective of achieving both gas barrier properties and coatability, the molecular weight is preferably 300 or more and 1,900 or less, more preferably 300 or more and 1,000 or less, even more preferably 350 or more and 1,000 or less, still more preferably 350 or more and 700 or less, and most preferably 350 or more and 500 or less.

Examples of the acrylic compound with a molecular weight of 300 or more include stearyl acrylate, methoxy PEG400 acrylate, methoxy PEG600 acrylate, methoxy PEG1000 acrylate, methoxy-polyethylene glycol acrylate, 2-acryloyloxyethyl-2-hydroxyethyl-phthalate, PEG200 diacrylate, PEG400 diacrylate, PEG600 diacrylate, PEG1000 diacrylate, tripropylene glycol diacrylate, polypropylene glycol diacrylate, polytetramethylene glycol diacrylate, tricyclodecane dimethanol diacrylate, neopentyl glycol hydroxypivalic acid ester diacrylate, bisphenol A ethylene glycol diether diacrylate, bisphenol A polyethylene glycol diether diacrylate, 1,6-hexanediylbis(oxy)bis(2-hydroxy-3,1-propanediyl)bisacrylate, bisphenol A diglycidyl ether acrylic acid adduct, glycerin 1,3-diglycerolate diacrylate, tris(2-hydroxyethyl)isocyanuric acid diacrylate, tris(2-hydroxyethyl)isocyanuric acid triacrylate, EO-modified trimethylolpropane triacrylate, pentaerythritol tetraacrylate, EO-modified pentaerythritol tetraacrylate, dipentaerythritol pentaacrylate, dipentaerythritol hexaacrylate, and EO-modified dipentaerythritol hexaacrylate.

In addition to the above compounds, epoxy acrylates, urethane acrylates, polyester acrylates, and the like with a molecular weight of 300 or more can also be used.

From the perspective of gas barrier properties, acrylic compounds having an isocyanurate skeleton can be used. For example, acrylic compounds having an isocyanurate skeleton such as tris(2-hydroxyethyl)isocyanuric acid diacrylate and tris(2-hydroxyethyl)isocyanuric acid triacrylate may be preferably used.

The active energy beam-curable resin composition may contain two or more acrylic compounds having an isocyanurate skeleton, from the perspective of adjusting coatability of the composition and other perspectives.

Gas barrier properties of organic polymers depend on the free volume and cohesive energy. The term free volume refers to inter-molecular spaces of the polymers, and the smaller these spaces, the higher the gas barrier properties. In order to suppress thermal motions of molecules, it is preferable to use a resin having a high glass transition temperature and increase the crosslinking density. Many acrylic resins have a relatively low glass transition temperature.

The term cohesive energy refers to energy related to the magnitude of interactions of functional groups or polar groups with the permeating gas. It is known that chloro groups, fluoro groups, hydroxyl groups, etc. effectively interact with oxygen gas, among which hydroxyl groups are particularly effective. Accordingly, in order to form an organic polymer film having excellent gas barrier properties, an acrylic compound having hydroxyl groups (hydroxyl group-containing acrylic compound) can be used.

Examples of the hydroxyl group-containing acrylic compound that can be used include 2-acryloyloxyethyl-2-hydroxyethyl-phthalate, 1,6-hexanediylbis(oxy)bis(2-hydroxy-3,1-propanediyl)bisacrylate, bisphenol A diglycidyl ether acrylic acid adduct, glycerin 1,3-diglycerolate diacrylate, tris(2-hydroxyethyl)isocyanuric acid diacrylate, and dipentaerythritol pentaacrylate.

When the number of acryloyl groups contained in one molecule of an acrylic compound is N_{A} and the number of hydroxyl groups therein is N_{B}, a value calculated from the following Formula (1) using N_{A} and N_{B} is preferably 4 or more. ${N}_{A} \times 2 + {N}_{B} \times 3 \geq 4$ (1)

When the value calculated from Formula (1) is 4 or more, crosslinking density is improved by the acryloyl groups compared to the case where the value is less than 4, and therefore a coating film having a dense structure can be easily formed. Thus, the coating film is less likely to allow oxygen molecules to permeate therethrough and better gas barrier properties can be easily achieved. From this perspective, the value calculated from Formula (1) is more preferably 5 or more, even more preferably 6 or more, and still more preferably 7 or more. The upper limit of the value calculated from Formula (1) can be 65, for example; however, the upper limit is preferably 30 or less, and more preferably 15 or less, from the perspective of suppressing embrittlement of the coating film due to excessively dense internal structure and easily maintaining handleability (flexibility) of the film.

The number of the acryloyl groups N_{A} contained in one molecule of the acrylic compound can be 1 to 15. N_{A} being one or more can allow a curing reaction to occur and N_{A} being 15 or less can easily maintain flexibility of the coating film. Therefore, cracking of the coating film or peeling of the coating film from the substrate layer is less likely to occur and gas barrier properties can be easily ensured. From this perspective, N_{A} may be preferably 2 to 10, more preferably 2 to 6, and even more preferably 3 to 6.

The number of the hydroxyl groups N_{B} contained in one molecule of the acrylic compound can be 0 to 20. The acrylic compound does not necessarily have to contain hydroxyl groups; however, containing hydroxyl groups as mentioned above tends to improve gas barrier properties. N_{B} being 20 or less can easily maintain an appropriate viscosity of the acrylic compound. Thus, good coatability can be achieved and a homogenous coating film can be easily formed. From this perspective, N_{B} may be preferably 0 to 15, and more preferably 1 to 8.

Examples of the acrylic compound that can be used having a value of 4 or more calculated from Formula (1) include tricyclodecane dimethanol diacrylate, 2-acryloyloxyethyl-2-hydroxyethyl-phthalate, 1,6-hexanediylbis(oxy)bis(2-hydroxy-3,1-propanediyl)bisacrylate, bisphenol A diglycidyl ether acrylic acid adduct, glycerin 1,3-diglycerolate diacrylate, tris(2-hydroxyethyl)isocyanuric acid diacrylate, tris(2-hydroxyethyl)isocyanuric acid triacrylate, EO-modified trimethylolpropane triacrylate, pentaerythritol tetraacrylate, EO-modified pentaerythritol tetraacrylate, dipentaerythritol pentaacrylate, dipentaerythritol hexaacrylate, and EO-modified dipentaerythritol hexaacrylate.

The active energy beam-curable resin composition may further contain an acrylic compound with a molecular weight of less than 300, from the perspective of coatability of the composition.

Specifically, the active energy beam-curable resin composition may contain an acrylic compound with a molecular weight of 300 or more and an acrylic compound with a molecular weight of less than 300.

Examples of acrylic compounds with a molecular weight of less than 300 that can be used include phenoxyethyl acrylate, 2-hydroxyethyl acrylate, 2-hydroxypropyl acrylate, 2-hydroxybutyl acrylate, 4-hydroxybutyl acrylate, ethoxy-diethylene glycol acrylate, methoxytriethylene glycol acrylate, methoxydipropylene glycol acrylate, butoxyethyl acrylate, butoxydiethylene glycol acrylate, butyl acrylate, isoamyl acrylate, hexyl acrylate, 2-ethylhexyl acrylate, lauryl acrylate, methoxyethylene glycol acrylate, methoxydiethylene glycol acrylate, methoxy PEG200 acrylate, 2-hydroxy-3-phenoxypropyl acrylate, 2-acryloyloxyethyl succinate, 2-acryloyloxyethyl hexahydrophthalate, 2-acryloyloxyethyl-phthalate, acrylic acid, 2-acryloyloxyethyl acid phosphate, dimethylaminoacrylate, diethylaminoacrylate, glycidyl acrylate, tetrahydrofurfuryl acrylate, cyclohexyl acrylate, phenoxyethyl acrylate, isobornyl acrylate, diethylene glycol diacrylate, triethylene glycol diacrylate, dipropylene glycol diacrylate, 1,4-butanediol diacrylate, 1,6-hexanediol diacrylate, 1,9-nonanediol diacrylate, neopentyl glycol diacrylate, glycerin diacrylate, glycerin triacrylate, trimethylolpropane triacrylate, pentaerythritol triacrylate, and 1-(acryloyloxy)-3-(methacryloyloxy)-2-propanol.

The active energy beam-curable composition may further contain a carboxyl group-containing acrylic compound as the acrylic compound with a molecular weight of less than 300, from the perspective of not only improving coatability of the composition but also improving adhesion between the overcoat layer, as a cured product of the composition, and the inorganic oxide layer. Carboxyl groups having polarity tend to strongly interact with the inorganic oxide layer, and therefore adhesion between the overcoat layer and the inorganic oxide layer tends to improve even more.

Specifically, the active energy beam-curable resin composition can contain an acrylic compound with a molecular weight of 300 or more and a carboxyl group-containing acrylic compound with a molecular weight of less than 300; however, this composition may contain an acrylic compound with a molecular weight of 300 or more, a carboxyl group-free acrylic compound with a molecular weight of less than 300, and a carboxyl group-containing acrylic compound with a molecular weight of less than 300.

Examples of the carboxyl group-containing acrylic compound that can be used include 2-carboxyethyl acrylate and ω-carboxycaprolactone monoacrylate, in addition to 2-acryloyloxyethyl succinate, 2-acryloyloxyethyl phthalate, 2-acryloyloxyethyl hexahydrophthalate, etc. mentioned above. Of these, 2-acryloyloxyethyl succinate or 2-acryloyloxyethyl hexahydrophthalate is preferable, and 2-acryloyloxyethyl succinate is more preferable, from the perspective of mixed suitability with the acrylic compound with a molecular weight of 300 or more, gas barrier properties, and the like.

The carboxyl group-containing acrylic compound with a molecular weight of 300 or more may have a size to fill the spaces in the crosslinked structure of the acrylic compound with a molecular weight of 300 or more. This makes it easy to obtain a synergistic effect of improving adhesion between the overcoat layer and the inorganic oxide layer and improving gas barrier properties. From this perspective, the molecular weight of the carboxyl group-containing acrylic compound may be preferably 250 or less, and more preferably 200 or less. However, from the perspective of curability of the composition, the molecular weight may be 100 or more. The molecular weight of the carboxyl group-containing acrylic compound is preferably 100 or more and less than 300, more preferably 100 or more and 250 or less, and even more preferably 100 or more and 200 or less.

From the perspective of forming a crosslinked structure inside the coating film as a result of EB curing or UV curing, it is preferable that at least one of the acrylic compounds used has two or more acryloyl groups.

From the perspective of reactivity control, heat resistance, and the like, the active energy beam-curable resin composition may further contain a methacrylic compound (compound having methacryloyl groups). Methacrylic compounds are also good active energy beam-curable resin compositions that can form organic polymer films at low cost.

As a methacrylic compound, any methacrylic compound having good EB or UV curability can be used.

Examples of the methacrylic compound that can be used include 2-hydroxyethyl methacrylate, 2-hydroxypropyl methacrylate, 2-hydroxybutyl methacrylate, ethoxydiethylene glycol methacrylate, methoxyethylene glycol methacrylate, methoxydiethylene glycol methacrylate, methoxytriethylene glycol methacrylate, methoxydipropylene glycol methacrylate, butoxyethyl methacrylate, butoxydiethylene glycol methacrylate, butyl methacrylate, isoamyl methacrylate, hexyl methacrylate, 2-ethylhexyl methacrylate, lauryl methacrylate, stearyl methacrylate, methoxy PEG200 methacrylate, methoxy PEG400 methacrylate, methoxy PEG600 methacrylate, methoxy PEG1000 methacrylate, methoxy-polyethylene glycol methacrylate, 2-hydroxy-3-phenoxypropyl methacrylate, 2-methacryloyloxyethyl succinate, 2-methacryloyloxyethyl hexahydrophthalate, 2-methacryloyloxyethyl phthalate, 2-methacryloyloxyethyl-2-hydroxyethyl-phthalate, 2-methacryloyloxyethyl-2-hydroxypropyl-phthalate, methacrylic acid, 2-methacryloyloxyethyl acid phosphate, dimethylaminoethyl methacrylate, diethylaminoethyl methacrylate, glycidyl methacrylate, tetrahydrofurfuryl methacrylate, cyclohexyl methacrylate, phenoxyethyl methacrylate, isobornyl methacrylate, diethylene glycol dimethacrylate, triethylene glycol dimethacrylate, PEG200 dimethacrylate, PEG400 dimethacrylate, PEG600 dimethacrylate, PEG1000 dimethacrylate, polyethylene glycol dimethacrylate, dipropylene glycol dimethacrylate, tripropylene glycol dimethacrylate, polypropylene glycol dimethacrylate, 1,4-butanediol dimethacrylate, 1,6-hexanediol dimethacrylate, 1,9-nonanediol dimethacrylate, ditetramethylene glycol dimethacrylate, tritetramethylene glycol dimethacrylate, neopentyl glycol dimethacrylate, tricyclodecane dimethanol dimethacrylate, neopentyl glycol hydroxypivalic acid ester dimethacrylate, bisphenol A ethylene glycol diether dimethacrylate, bisphenol A polyethylene glycol diether dimethacrylate, glycerin dimethacrylate, 1,6-hexanediylbis(oxy)bis(2-hydroxy-3,1-propanediyl)bismethacrylate, bisphenol A diglycidyl ether methacrylic acid adduct, glycerin 1,3-diglycerolate dimethacrylate, tris(2-hydroxyethyl)isocyanuric acid dimethacrylate, tris(2-hydroxyethyl)isocyanuric acid trimethacrylate, trimethylolpropane trimethacrylate, EO-modified trimethylolpropane trimethacrylate, glycerin trimethacrylate, pentaerythritol trimethacrylate, pentaerythritol tetramethacrylate, EO-modified pentaerythritol tetramethacrylate, dipentaerythritol pentamethacrylate, dipentaerythritol hexamethacrylate, and 1-(acryloyloxy)-3-(methacryloyloxy)-2-propanol.

In addition to the above compounds, epoxy methacrylates, urethane methacrylates, polyester methacrylates, and the like can also be used.

Similarly to the acrylic compound, from the perspective of forming an organic polymer film having excellent gas barrier properties, a compound containing methacryloyl groups having hydroxyl groups (hydroxyl group-containing methacrylic compounds) can be used.

Examples of the hydroxyl group-containing methacrylic compound that can be used include 2-hydroxyethyl methacrylate, 2-hydroxypropyl methacrylate, 2-hydroxybutyl methacrylate, 2-hydroxy-3-phenoxypropyl methacrylate, 2-methacryloyloxyethyl-2-hydroxyethyl-phthalate, 2-methacryloyloxyethyl-2-hydroxypropyl-phthalate, glycerin dimethacrylate, 1,6-hexanediylbis(oxy)bis(2-hydroxy-3,1-propanediyl) bismethacrylate, bisphenol A diglycidyl ether methacrylic acid adduct, glycerin 1,3-diglycerolate dimethacrylate, tris(2-hydroxyethyl)isocyanuric acid dimethacrylate, pentaerythritol trimethacrylate, and dipentaerythritol pentamethacrylate.

The content of the acrylic compound with a molecular weight of 300 or more can be 5 mass% or more, preferably 10 mass% or more, more preferably 30 mass% or more, and even more preferably 50 mass% or more relative to the total mass of the acrylic compound contained in the active energy beam-curable resin composition. If the content is 5 mass% or more, gas barrier properties are easily enhanced compared to the case where the content is less than 5 mass%. The upper limit of the content can be 100 mass%, although it is not particularly limited.

If the active energy beam-curable resin composition contains an acrylic compound with a molecular weight of less than 300, the content thereof can be 10 to 2,000 parts by mass, and preferably 50 to 1,000 parts by mass relative to 100 parts by mass of the acrylic compound with a molecular weight of 300 or more. If the content is 10 parts by mass or more, coatability of the composition (coating liquid) is easily improved, and if the content is 2,000 parts by mass or less, good gas barrier properties can be easily maintained.

If the active energy beam-curable resin composition contains a carboxyl group-containing acrylic compound with a molecular weight of less than 300, the content thereof can be 10 to 600 parts by mass relative to 100 parts by mass of the acrylic compound with a molecular weight of 300 or more. If the content is 10 parts by mass or more, coatability of the composition (coating liquid) and adhesion are easily improved, and if the content is 600 parts by mass or less, good gas barrier properties can be easily maintained.

From the perspective of achieving coatability, adhesion, and gas barrier properties with good balance, the content of the carboxyl group-containing acrylic compound with a molecular weight of less than 300 is preferably 10 to 600 parts by mass, more preferably 10 to 300 parts by mass, even more preferably 20 to 300 parts by mass, still more preferably 20 to 200 parts by mass, and most preferably 20 to 100 parts by mass relative to 100 parts by mass of the acrylic compound with a molecular weight of 300 or more.

If the active energy beam-curable resin composition contains two or more acrylic compounds having an isocyanurate skeleton, the content of a hydroxyl group-containing acrylic compound having an isocyanurate skeleton can be 30 mass% or more, preferably 50 mass% or more, and even more preferably 70 mass% or more relative to the total mass of the acrylic compounds having an isocyanurate skeleton. If the content is 30 mass% or more, gas barrier properties tend to improve compared to the case of less than 30 mass%. The upper limit of the content can be 100 mass%, although it is not particularly limited.

From the perspective of gas barrier properties, the active energy beam-curable resin composition may contain an acrylic compound in an amount of 50 mass% or more, preferably 70 mass% or more, and more preferably 80 mass% or more. The upper limit of the content can be 100 mass%, although it is not particularly limited.

The active energy beam-curable resin composition may contain a photoradical generator as necessary. Any photoradical generator can be used as long as it generates radicals by EB or UV irradiation. Examples of the photoradical generator include, although it is not particularly limited, benzil dimethyl ketal, 1-hydroxycyclohexyl phenyl ketone, diethylthioxanthone, benzophenone, 2-ethylanthraquinone, 2-hydroxy-2-methylpropiophenone, 2-methyl-[4-(methylthio)phenyl]-2-morpholino-1-propane, 2,4,6-trimethylbenzoyldiphenylphosphine oxide, camphorquinone, 9-fluorenone, and diphenyl disulfide.

The active energy beam-curable resin composition may contain a silane coupling agent as necessary. From the perspective of EB or UV curability, a silane coupling agent having acryloyl groups or methacryloyl groups is preferable. Examples of such a silane coupling agent include 3-methacryloyloxypropylmethyldimethoxysilane, 3-methacryloyloxypropyltrimethoxysilane, 3-methacryloyloxypropylmethyldiethoxysilane, 3-methacryloyloxypropyltriethoxysilane, and 3-acryloyloxypropyltrimethoxysilane.

The thickness of the overcoat layer 20 is determined according to the gas barrier properties as required and can be, for example, preferably 0.05 µm to 10 µm, more preferably 0.1 µm to 5 µm, even more preferably 0.1 µm to 2 µm, even more preferably 0.15 µm to 2 µm, even more preferably 0.2 µm to 2 µm, even more preferably 0.2 µm to 1.5 µm, even more preferably 0.2 µm to 1 µm, and even more preferably 0.3 µm to 1 µm. If the thickness of the overcoat layer 20 is 0.05 µm or more, more preferably 0.1 µm or more, even more preferably 0.2 µm or more, and even more preferably 0.3 µm or more, sufficient gas barrier properties can be easily achieved. On the other hand, from the perspective of improving curability (excessive thickness may take time for curing) and from the perspective of improving adhesion between the overcoat layer and the inorganic oxide layer, the thickness can be preferably 10 m or less, more preferably 5 µm or less, even more preferably 1.5 µm or less, and most preferably 1 µm or less.

### <Method of producing gas barrier film>

The method of producing a gas barrier film includes steps of
forming an inorganic oxide layer on a substrate layer;
applying an active energy beam-curable resin composition onto the inorganic oxide layer to form a coating film; and
irradiating the coating film with active energy beams to form an overcoat layer, wherein
the active energy beam-curable resin composition contains an acrylic compound with a molecular weight of 300 or more.

An example of the procedure for producing a gas barrier film will be described.

First, a substrate layer 10 is prepared. The substrate layer 10 may be a commercially available substrate layer, or may be prepared using a known method.

Next, a primer layer 30 and an inorganic oxide layer 40, or only an inorganic oxide layer 40, are formed on the substrate layer 10.

If a primer layer 30 is formed, for example, a primer layer-forming coating agent may be applied to the substrate layer 10 using a wet coating method to form a coating film, and then the coating film may be dried (to remove the solvent) for curing.

The coating agent can be applied using a known wet coating method. The wet coating method may be roll coating, gravure coating, reverse coating, die coating, screen printing, spray coating, or the like.

The method of drying the coating film may be a known drying method such as hot-air drying, hot-roll drying, and infrared radiation. The drying temperature for the coating film may be, for example, 50 to 200°C. The drying time depends on the thickness of the coating film, the drying temperature, and the like, but can be 1 second to 5 minutes, for example. The drying conditions for the coating film may be appropriately determined considering ease of drying the solvent in the coating film, thermal stability of the substrate layer 10, and the like.

The inorganic oxide layer 40 can be formed on the substrate layer 10 or on the primer layer 30 using vacuum vapor deposition, sputtering, ion plating, plasma-enhanced chemical vapor deposition (CVD), or the like mentioned above.

Subsequently, an overcoat layer 20 is formed.

The overcoat layer 20 can be formed, for example, by applying an overcoat layer-forming coating agent (the active energy beam-curable resin composition described above) on the inorganic oxide layer 40 using wet coating to form a coating film, and irradiating the coating film with EB or UV radiation for curing.

The irradiation conditions of the active energy beams depend on the thickness of the overcoat layer 20, but may be an acceleration voltage of 10 to 300 kV and an irradiation dose of 15 to 120 kGy. If the acceleration voltage is in the above range, active energy beams can easily reach a sufficiently deep position of the coating film in the thickness direction, and deterioration of the inorganic oxide layer, primer layer, substrate layer, and the like due to active energy beams is easily suppressed. If the irradiation dose is in the above range, a desired crosslinked structure can be easily formed inside the layer, while suppressing yellowing or change in physical properties of the overcoat layer 20.

Application methods similar to those mentioned in the description for forming the primer layer 30 can be used as a method of applying the coating agent.

The overcoat layer 20 may be formed through single application and curing, or may be formed through multiple times of application and curing using the same coating agent or different coating agents.

The overcoat layer 20 formed as described above is a cured product of a coating agent (active energy beam-curable resin composition) having a crosslinked structure. The expression "having a crosslinked structure" refers to the molecular chains of the reactive compound that contains an acrylic compound forming a three-dimensional mesh structure. The presence of a crosslinked structure can be confirmed through various analyses, examples of which include Fourier transform infrared spectroscopy, solid-state NMR measurement, X-ray photoelectron spectroscopy, dynamic viscoelastic measurement, and gel fraction measurement.

The gas barrier film may be further provided with, as necessary, a printed layer, protective layer, light-shielding layer, adhesive layer, heat-sealable heat-sealing layer, other functional layers, and the like.

### <Packaging film and packaging material>

A packaging film includes the gas barrier film described above and a heat-sealing layer provided on the overcoat layer of the gas barrier film. A packaging material can be formed by placing one packaging film or multiple packaging films so that surfaces of the heat-sealing layer(s) face with each other, and by heat-sealing the circumferential edges of the film(s). Specifically, the packaging material is obtained by forming the packaging film into a bag shape.

As the heat-sealing layer, CPP (unstretched polypropylene) can be exemplified. The heat-sealing layer can be laminated on the substrate layer using a known adhesive such as a polyurethane-, polyester-, or polyether-based adhesive using a known dry lamination method, extrusion lamination method, or the like.

By forming both the substrate layer and the heat-sealing layer using a polypropylene, the content of the polypropylene in the packaging film and the packaging material can be 90 mass% or more. Thus, the packaging film and the packaging material can be so-called monomaterials having excellent recyclability.

### Examples

The gas barrier film according to the present disclosure will be further described using examples and comparative examples. The present disclosure should not be limited in any way by the specific contents of the examples and comparative examples.

### (Example 1)

### [Preparation of substrate layer]

As a substrate layer 10, a biaxially stretched polypropylene film having a thickness of 20 µm with one surface thereof corona-treated (VPH2011 manufactured by A.J. Plast) was prepared.

### [Formation of inorganic oxide layer]

A mixed material containing two or more of metallic silicon, silicon monoxide, and silicon dioxide was evaporated using a vacuum deposition device employing an electron beam heating method to form an inorganic oxide film 40 made of a silicon oxide and having a thickness of 30 nm (silicon oxide deposition layer) on the corona-treated surface of the substrate layer 10.

### [Formation of overcoat layer]

A coating liquid (active energy beam-curable resin composition) prepared through the following procedure was formed on the inorganic oxide layer 40 using a flexographic printing machine to form a coating film. Then, the coating film was irradiated with EB for curing using an electron beam irradiation device manufactured by Eye Electron Beam Co., Ltd. at an acceleration voltage of 120 kV and an irradiation dose of 15 kGy in a nitrogen atmosphere with an oxygen concentration of 100 ppm or less. The obtained overcoat layer had a thickness of 1 µm. In this way, a gas barrier film including substrate layer 10 / inorganic oxide layer 40 / overcoat layer 20 in this order was obtained.

### (Procedure for preparing coating liquid)

The acrylic compounds used are shown in Table 1. In Example 1, tricyclodecane dimethanol diacrylate (product name: LIGHT ACRYLATE DCP-A manufactured by Kyoeisha Chemical Col, Ltd.) was used as an acrylic compound.

### (Examples 2 to 6 and Comparative Examples 1 to 3)

Gas barrier films were obtained as in Example 1 except that the acrylic compounds shown in Table 1 were used. Molecular weights, values of the above Formula (1), and presence or absence of an isocyanurate skeleton are also shown in Table 1.

### (Comparative Example 4)

A gas barrier film was obtained as in Example 1 except that no overcoat layer was formed.

Details of the acrylic compounds used are as follows.
1,6-hexanediylbis(oxy)bis(2-hydroxy-3,1-propanediyl)bisacrylate (product name: KAYARAD R-167 manufactured by Nippon Kayaku Co.,Ltd.)
2-acryloyloxyethyl-2-hydroxyethyl-phthalate (product name: LIGHT ACRYLATE HOA-MPE(N) manufactured by Kyoeisha Chemical Col, Ltd.)
Bisphenol A diglycidyl ether acrylic acid adduct (product name: EPOXY ESTER 3000A manufactured by Kyoeisha Chemical Col, Ltd.)
Tris(2-hydroxyethyl)isocyanuric acid triacrylate (product name: A-9300 manufactured by Shin-Nakamura Chemical Co., Ltd.)
Tris(2-hydroxyethyl)isocyanuric acid diacrylate (product name: M-215 manufactured by Toagosei Co., Ltd.)
Butyl acrylate (product name: Butyl Acrylate manufactured by Tokyo Chemical Industry Co., Ltd.)
Dipropylene glycol diacrylate (product name: Dipropylene Glycol Diacrylate manufactured by Tokyo Chemical Industry Co., Ltd.)
Neopentyl glycol diacrylate (product name: A-NPG manufactured by Shin-Nakamura Chemical Co., Ltd.)

**[Table 1]**

| | Compound | Molecular weight | Value of Formula (1) | Isocyanurate skeleton present? |
|---|---|---|---|---|
| Ex. 1 | Tricyclodecane dimethanol diacrylate | 304 | 4 | No |
| Ex. 2 | 1,6-hexanediylbis(oxy)bis(2-hydroxy-3,1-propanediyl)bisacrylate | 374 | 10 | No |
| Ex. 3 | 2-acryloyloxyethyl-2-hydroxyethyl-phthalate | 308 | 5 | No |
| Ex. 4 | Bisphenol A diglycidyl ether acrylic acid adduct | 485 | 10 | No |
| Ex. 5 | Tris(2-hydroxyethyl)isocyanuric acid triacrylate | 423 | 6 | Yes |
| Ex. 6 | Tris(2-hydroxyethyl)isocyanuric acid diacrylate | 369 | 7 | Yes |
| Comp. Ex. 1 | Butyl acrylate | 128 | 2 | No |
| Comp. Ex. 2 | Dipropylene glycol diacrylate | 242 | 4 | No |
| Comp. Ex. 3 | Neopentyl glycol diacrylate | 212 | 4 | No |

For the gas barrier films obtained in the examples and comparative examples, the following evaluation was performed. The results are shown in Table 2.

### (Curability)

Curing of the overcoat layers of the gas barrier films was examined based on the tackiness felt when the layers were rubbed with a latex glove. If the overcoat layer was neither scratched nor sticky, the gas barrier film was evaluated to be Good, and if it was scratched or sticky, evaluated to be Poor.

### (Oxygen barrier properties)

For the gas barrier films obtained in the examples and comparative examples, oxygen transmission rate (cc/(m²·day·atm)) was measured using an oxygen transmission rate measuring device (product name: OXTRAN-2/20 manufactured by Mocon Inc.) in an atmosphere of 30°C and 70% RH (relative humidity). For the examples or comparative examples whose curability was evaluated to be Poor, oxygen barrier properties were not evaluated because handling was difficult due to the sticky overcoat layer surface.

As shown in Table 2, it is considered that by using an acrylic compound with a molecular weight of 300 or more, a strong coating film was formed by active energy beam curing and excellent oxygen barrier properties were exhibited.

**[Table 2]**

| | Film thickness [µm] | Curability | Oxygen transmission rate [cc/m²/day/atm] |
|---|---|---|---|
| Ex. 1 | 1 | Good | 11.6 |
| Ex. 2 | 1 | Good | 7.0 |
| Ex. 3 | 1 | Good | 4.2 |
| Ex. 4 | 1 | Good | 3.9 |
| Ex. 5 | 1 | Good | 3.1 |
| Ex. 6 | 1 | Good | 0.5 |
| Comp. Ex. 1 | 1 | Poor | - |
| Comp. Ex. 2 | 1 | Good | 20.2 |
| Comp. Ex. 3 | 1 | Good | 25.6 |
| Comp. Ex. 4 | - | - | 41.0 |

Examples 2 to 4, in which the value of Formula (1) was 5 or more, exhibited better oxygen barrier properties than in Example 1. This is considered to be because, with the value of Formula (1) being 5 or more, the balance between the improvement in crosslinking density due to the acryloyl groups and the interactions inside the coating film due to the hydroxyl groups was further optimized, allowing the coating film to have a denser structure and to be less permeable to oxygen molecules accordingly.

Examples 5 and 6, each using an acrylic compound having an isocyanurate skeleton, exhibited even better oxygen barrier properties. This is considered to be because the acrylic compound having an isocyanurate skeleton, which in general has a relatively high glass transition temperature among acrylic compounds, suppressed thermal motion of molecules in the internal structure of the coating film, allowing the coating film to have an increased density and to be much less permeable to oxygen molecules accordingly.

As is clear from Comparative Examples 1 to 3, use of an acrylic compound with a molecular weight of less than 300 resulted in insufficient curing, or resulted in that satisfactory oxygen barrier properties were not achieved although curing was sufficient.

### (Example 7)

As an acrylic compound, a mixture obtained by mixing tris(2-hydroxyethyl)isocyanuric acid triacrylate having an isocyanurate skeleton and having no hydroxyl groups (product name: A-9300 manufactured by Shin-Nakamura Chemical Co., Ltd.) (A) with tris(2-hydroxyethyl)isocyanuric acid diacrylate having an isocyanurate skeleton and having hydroxyl groups (product name: M-215 manufactured by Toagosei Co., Ltd.) (B) in a mass ratio of A:B=75:25 was used. Other than the above, a gas barrier film was obtained as in Example 1.

### (Examples 8 to 10)

Gas barrier films were obtained as in Example 7 except that the mass ratio of A and B was changed as shown in Table 3.

**[Table 3]**

| | Mixing ratio [mass%] | | Oxygen transmission rate [cc/m²/day/atm] |
|---|---|---|---|
| | (A) | (B) | |
| Ex. 7 | 75 | 25 | 2.2 |
| Ex. 8 | 50 | 50 | 1.1 |
| Ex. 9 | 25 | 75 | 0.7 |
| Ex. 10 | 10 | 90 | 0.6 |

Even when a mixture obtained by mixing two compounds having different isocyanurate skeletons was used as an acrylic compound, good oxygen barrier properties were resultantly exhibited. In particular, Examples 8 to 10, in which the content of Compound (B) having hydroxyl groups was 30 mass% or more, exhibited better oxygen barrier properties than in Example 7. This is considered to be because diffusion of oxygen molecules was further suppressed due to the presence of hydroxyl groups having a high affinity for oxygen molecules in the coating film having isocyanurate skeletons in the structure thereof.

### (Example 11)

As an acrylic compound, a mixture obtained by mixing tris(2-hydroxyethyl)isocyanuric acid diacrylate (product name: M-215 manufactured by Toagosei Co., Ltd.) (C) with glycerin diacrylate (product name: M-920, molecular weight: 200 manufactured by Toagosei Co., Ltd.) (D) in a mass ratio of C:D = 70:30 was used. Other than the above, a gas barrier film was obtained as in Example 1.

The viscosity shown in Table 4 is the viscosity of the coating liquid at a shear rate of 100 (1/s) when the viscosity thereof was continuously measured at a shear rate of 1 (1/s) to 1,000 (1/s) using a rheometer (HAAKE MARS manufactured by Thermo Scientific) with a cone-plate (diameter: 60 mm, cone angle: 1°) in a temperature condition of 23°C.

### (Examples 12 to 14)

Gas barrier films were obtained as in Example 11 except that the mass ratio of C and D was changed as shown in Table 4.

### (Example 15)

As an acrylic compound, a mixture obtained by mixing tris(2-hydroxyethyl)isocyanuric acid diacrylate (product name: M-215 manufactured by Toagosei Co., Ltd.) (C) with 1-(acryloyloxy)-3-(methacryloyloxy)-2-propanol (product name: 1-(Acryloyloxy)-3-(methacryloyloxy)-2-propanol, molecular weight: 214 manufactured by Tokyo Chemical Industry Co., Ltd.) (E) in a mass ratio of C:E = 70:30 was used. Other than the above, a gas barrier film was obtained as in Example 1.

### (Examples 16 to 18)

Gas barrier films were obtained as in Example 15 except that the mass ratio of C and E was changed as shown in Table 4.

**[Table 4]**

| | Mixing ratio [mass%] | | | Oxygen transmission rate [cc/m²/day/atm] | Viscosity [mPa·s] |
|---|---|---|---|---|---|
| | (C) | (D) | (E) | | |
| Ex. 11 | 70 | 30 | - | 0.8 | 1,218 |
| Ex. 12 | 50 | 50 | - | 0.8 | 378 |
| Ex. 13 | 30 | 70 | - | 1.4 | 153 |
| Ex. 14 | 15 | 85 | - | 1.6 | 83 |
| Ex. 15 | 70 | - | 30 | 0.8 | 1,266 |
| Ex. 16 | 50 | - | 50 | 1.6 | 398 |
| Ex. 17 | 30 | - | 70 | 3.0 | 158 |
| Ex. 18 | 15 | - | 85 | 10.1 | 86 |

By combining an acrylic compound with a molecular weight of 300 or more having excellent oxygen barrier properties with an acrylic compound having a low viscosity, coatability of the coating liquid can be improved, while maintaining excellent oxygen barrier properties. By adjusting viscosity without using a solvent, heat drying processing is no longer required for the coating film, thereby suppressing dimensional changes of the substrate film and occurrence of cracking in the inorganic oxide layer accompanying the dimensional changes.

### (Example 19)

As an acrylic compound, a mixture obtained by mixing 2-acryloyloxyethyl-2-hydroxyethyl-phthalate (product name: LIGHT ACRYLATE HOA-MPE(N) manufactured by Kyoeisha Chemical Col, Ltd.) (F) with 2-acryloyloxyethyl succinate (product name: LIGHT ACRYLATE HOA-MS(N), molecular weight: 216 manufactured by Kyoeisha Chemical Col, Ltd.) (G) in a mass ratio of F:G = 50:50 was used. Other than the above, a gas barrier film was obtained as in Example 1.

### (Example 20)

Instead of G, 2-acryloyloxyethyl hexahydrophthalate (product name: LIGHT ACRYLATE HOA-HH(N), molecular weight: 270 manufactured by Kyoeisha Chemical Col, Ltd.) (H) was used. Other than the above, a gas barrier film was obtained as in Example 19.

### (Example 21)

Instead of G, 2-acryloyloxyethyl phthalate (product name: M-5400, molecular weight: 264 manufactured by Toagosei Co., Ltd.) (I) was used. Other than the above, a gas barrier film was obtained as in Example 19.

### (Example 22)

As an acrylic compound, a mixture obtained by mixing 2-acryloyloxyethyl succinate (product name: LIGHT ACRYLATE HOA-MS(N), molecular weight: 216 manufactured by Kyoeisha Chemical Col, Ltd.) (G) with tris(2-hydroxyethyl)isocyanuric acid diacrylate (product name: M-215 manufactured by Toagosei Co., Ltd.) (J) in a mass ratio of G:J = 70:30 was used. Other than the above, a gas barrier film was obtained as in Example 1.

### (Example 23)

A gas barrier film was obtained as in Example 22 except that the mixing mass ratio was G:J = 85:15.

### (Adhesion)

Adhesion between the overcoat layer and the inorganic oxide layer was evaluated according to the "X-cut tape method" of JIS K 5400. In this method, thin cross-shaped cuts are formed in the overcoat layer with a cutter, and cellophane tape is applied over the cuts and then removed to examine how much of the overcoat layer remained on the film. If the overcoat layer did not peel off at all, the film was evaluated to be Good, but if the layer peeled off even slightly, the film was evaluated to be Poor.

**[Table 5]**

| | Mixing ratio [mass%] | | | | | Oxygen transmission rate [cc/m²/day/atm] | Adhesion [mPa·s] |
|---|---|---|---|---|---|---|---|
| | (F) | (G) | (H) | (I) | (J) | | |
| Ex. 19 | 50 | 50 | - | - | - | 1.9 | Good |
| Ex. 20 | 50 | - | 50 | - | - | 1.4 | Good |
| Ex. 21 | 50 | - | - | 50 | - | 2.3 | Good |
| Ex. 22 | - | 70 | - | - | 30 | 1.6 | Good |
| Ex. 23 | - | 85 | - | - | 15 | 2.7 | Good |

As shown in Table 5, the adhesion testing conducted for Examples 19 to 23 all resulted in Good. By using a carboxyl group-containing acrylic compound with a molecular weight of less than 300 in combination with an acrylic compound with a molecular weight of 300 or more having excellent oxygen barrier properties, it was shown that improvement in adhesion between the overcoat layer and the inorganic oxide layer worked synergistically with improvement in oxygen barrier properties.

Some embodiments and examples of the present disclosure have so far been described; however, specific configurations of the present disclosure are not limited to these embodiments and examples, but the configurations can be modified or combined in any way as long as they do not depart from the spirit of the present disclosure.

### [Reference Signs List]

10 ... Substrate layer
20 ... Overcoat layer
30 ... Primer layer
40 ... Inorganic oxide layer
100, 200 ... Gas barrier film

## Claims

1. A method of producing a gas barrier film, comprising steps of
forming an inorganic oxide layer on a substrate layer;
applying an active energy beam-curable resin composition onto the inorganic oxide layer to form a coating film; and
forming an overcoat layer by irradiating the coating film with active energy beams and curing the coating film, wherein
the active energy beam-curable resin composition contains an acrylic compound with a molecular weight of 300 or more.

2. A gas barrier film, comprising
a substrate layer, an inorganic oxide layer, and an overcoat layer in this order, wherein
the overcoat layer is a cured product of an active energy beam-curable resin composition having a crosslinked structure; and
the active energy beam-curable resin composition contains an acrylic compound with a molecular weight of 300 or more.

3. The gas barrier film according to claim 2, wherein the active energy beam-curable resin composition contains the acrylic compound having an isocyanurate skeleton.

4. The gas barrier film according to claim 3, wherein the active energy beam-curable resin composition contains two or more types of the acrylic compound having an isocyanurate skeleton.

5. The gas barrier film according to claim 3, wherein a content of a hydroxyl group-containing acrylic compound having an isocyanurate skeleton is 30 mass% or more relative to a total mass of the acrylic compound having an isocyanurate skeleton.

6. The gas barrier film according to claim 2, wherein the active energy beam-curable resin composition further contains an acrylic compound with a molecular weight of less than 300.

7. The gas barrier film according to claim 2, wherein the active energy beam-curable resin composition further contains a carboxyl group-containing acrylic compound with a molecular weight of less than 300.

8. The gas barrier film according to claim 2, wherein the substrate layer contains a polyolefin-based resin.

9. The gas barrier film according to claim 2, wherein the overcoat layer has a thickness of 0.15 µm to 2 µm.

10. A packaging film comprising the gas barrier film according to any one of claims 2 to 9, and a heat-sealing layer provided on the overcoat layer of the gas barrier film.

11. A packaging material formed into a bag shape from the packaging film according to claim 10.
